Europäisches Patentamt

European Patent Office

Office européen des brevets

(11) Veröffentlichungsnummer: **0 591 942 A1**

# (12) EUROPÄISCHE PATENTANMELDUNG

(21) Anmeldenummer: **93116159.0**

(22) Anmeldetag: **06.10.93**

(51) Int. Cl.5: **G01R 21/00**, G01R 21/133, G01R 11/20

(30) Priorität: **08.10.92 DE 9213457 U**

(43) Veröffentlichungstag der Anmeldung:
**13.04.94 Patentblatt 94/15**

(84) Benannte Vertragsstaaten:
**CH DE ES FR GB IT LI SE**

(71) Anmelder: **Gossen- Metrawatt GmbH**
**Thomas-Mann-Strasse 20**
**D-8500 Nürnberg(DE)**

(72) Erfinder: **Riess, Herbert**
**Viatistrasse 4g**
**D-90480 Nürnberg(DE)**
Erfinder: **Hiltner, Heinz**
**Burgthanner Strasse 19a**
**D-90592 Schwarzenbruck(DE)**
Erfinder: **Piepmeier, Uwe**
**Obere Turnstrasse 5,**
**D-90429 Nürnberg(DE)**

(74) Vertreter: **Hafner, Dieter, Dr.rer.nat.,**
**Dipl.-Phys.**
**Dr. Hafner & Stippl,**
**Patentanwälte,**
**Ostendstrasse 132**
**D-90482 Nürnberg (DE)**

(54) **Elektronische Anordnung zur Erfassung von Messgrössen wie Wirkleistung, Blindleistung, Wirktaktor und Blindfaktor.**

(57) Die Erfindung betrifft eine elektronische Anordnung zur Erfassung von Meßgrößen wie Wirkleistung, Blindleistung, Wirkfaktor und Blindfaktor, insbesondere nach DIN 40110, in einem Einphasen- oder Mehrphasensystem, bei welchem Spannungs- und Stromwandler sekundärseitig sternförmig zusammengeschaltet und digital abtastbar sind. Die Ausgänge der Spannungs- und Stromwandler ($U_1$, $U_2$, $U_3$; $I_1$, $I_2$, $I_3$) sind mit je einem Anpassungsverstärker verbunden. Eine Mehrzahl von Sample-Hold-Speichereinheiten ist eingangsseitig mit dem Ausgang des zugeordneten Anspassungsverstärkers verbunden. Der Ausgang einer jeden Sample-Hold-Speichereinheit ist mit den Eingängen eines Multiplexers verbunden, wobei eine analoge Zwischenspeicherung der Momentanwerte aller Eingangsgrößen für die Dauer der nachfolgenden seriellen Analog/Digital-Wandlung in einem mit dem Multiplexer ausgangsseitig verbundenen Analog/Digital-Konverter vorgesehen ist und wobei die Spannungs- und Stromvektoren der Wandler ($U_1$, $U_2$, $U_3$; $I_1$, $I_2$, $I_3$) auf der Sekundärseite mit einem Phasenfehler abgebildet sind. Mit dem Multiplexer und/oder den Sample-Hold-Speichereinheiten und/oder dem Analog/Digital-Konverter ist ein Mikroprozessor (14) verbunden, mit dem die jeweiligen Abtastzeitpunkte t1, t2 ... tn der Sample-Hold-Einheiten um einen Fehlbetrag $t_{Fx}$ verschiebbar sind und wobei solche Momentanwerte der Eingangsgrößen verknüpfbar sind, die mit einer synchronen Abtastung zeitlich korrelieren.

EP 0 591 942 A1

**FIG.1**

2

Die Neuerung/Erfindung betrifft eine elektrische Anordnung zur Erfassung von Meßgrößen wie Wirkleistung, Blindleistung, Wirkfaktor und Blindfaktor mit den weiteren Merkmalen des Oberbegriffes des Patentanspruchs 1.

Um in einem Einphasen- bzw. Mehrphasensystem elektrische Meßgrößen wie Wirkleistung, Blindleistung, Wirkfaktor und Blindfaktor nach DIN 40110 zu messen, werden Spannungs- und Stromwandler sekundärseitig sternförmig zusammengeschaltet und digital abgetastet. Dabei ist die Wirkleistung definiert als

$$\text{Wirkleistung} \quad P = \frac{1}{n} \sum_{k=1}^{n} U_K \times I_K$$

$$\text{Blindleistung} \quad Q = \frac{1}{n} \sum_{k=1}^{n} U_K \times I_{k+n/4}$$

Wirkfaktor PF $= \frac{P}{S}$
Blindfaktor QF $= \frac{Q}{S}$

Mit Anpassungsverstärkern werden die Momentanwerte aller Eingangsgrößen erfaßt und für die Dauer der seriell erfolgenden A/D-Wandlung kurzzeitig analog gespeichert. Die Spannungs- und Stromvektoren der Wechselstromnetze werden jedoch mit einem Phasenfehler der Wandler auf der Sekundärseite abgebildet.

Zwar ist es bei Geräten nach dem Stand der Technik auch bereits möglich, durch komplizierte Korrekturschaltungen mit einer Reihe von zusätzlichen Bauteilen und aufwendigen Abgleichschritten in der Gerätefertigung eine Kompensation der Phasenfehler zu erreichen. Trotz des Aufwandes ergibt sich dabei aber ein frequenzabhängiger Meßfehler, der nur einen eingeschränkten Frequenzarbeitsbereich der Geräte nach dem Stand der Technik zu läßt.

Der Erfindung liegt die Aufgabe zugrunde, eine Vorrichtung mit den Merkmalen des Oberbegriffes des Anspruches 1 derart weiterzubilden, daß Phasenfehler ausgeglichen werden können.

Die Aufgabe wird durch die weiteren Merkmale des Anspruches 1 gelöst. Eine vorteilhafte Weiterbildung der Anordung ergibt sich aus Anspruch 2. Ein Meßverfahren ist Gegenstand der Ansprüche 3 - 5.

Bei einem digitalen System kann der auftretende Phasenfehler auf einfache Weise dadurch korrigiert werden, daß bei einer bestimmten Frequenz die Abtastzeitpunkte t1, t2 ... um einen gewissen Fehlbetrag $t_{Fx}$ zeitlich verschoben werden. Nach dieser Korrektur lassen sich die Werte miteinander verknüpfen, die mit einer synchronen Abtastung zeitlich korreliert sind.

Die Erfindung ist anhand von zwei Zeichnungsfiguren näher erläutert. Diese zeigen:

Fig. 1    ein Prinzipschaltbild zur Erläuterung der Struktur der digitalen Meßdatenverarbeitungsanordnung,

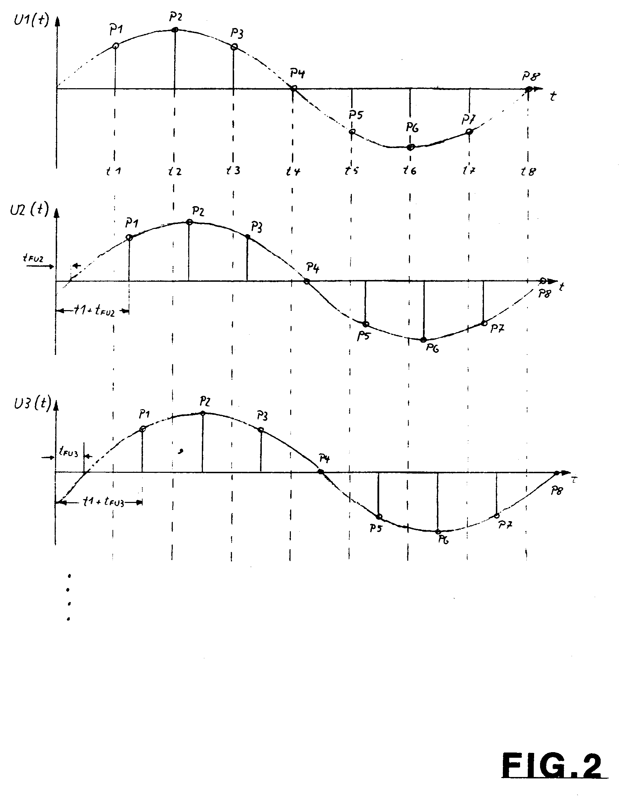

Fig. 2    Spannungs/Zeitdiagramme zur Erläuterung der zeitlichen Verschiebung der Abtastzeitpunkte t1, t2 ... nach der Erfindung.

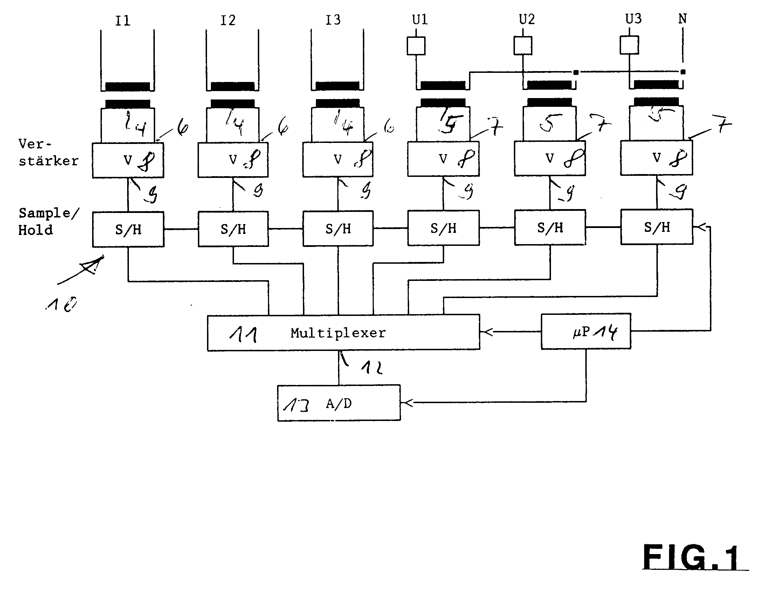

Zunächst wird auf Fig. 1 Bezug genommen. Dort sind mit $I_1$, $I_2$, $I_3$ bzw. $U_1$, $U_2$, $U_3$ Stromwandler bzw. Spannungswandler bezeichnet. Deren Ausgänge 4, 5 sind mit den Eingängen 6, 7 von Anpassungsverstärker 8 verbunden, deren Ausgänge zu Sample-Hold-Einheiten geführt sind, in denen der ermittelte Wert der Eingangsgrößen erfaßt und zwischengespeichert wird. Die Sample-Hold-Einheiten sind mit einem Multiplexer 11 verschaltet, dessen Ausgang 12 zu einem A/D-Wandler geführt ist. A/D-Wandler 13, Multiplexer 11 und Sample-Hold-Einheiten 10 werden durch einen μ-Prozessor 14 gesteuert.

Aus Zeichnungsfig. 2 ergibt sich der Betrag der zeitlichen Verschiebung $t_F U_2$ bzw $t_F U_3$, die sich gegenüber der Phasenlage der Spannung $U_1$ (t) ergibt.

Analog werden für $I_1$ (t), $I_2$ (t) und $I_3$ (t) Phasenverschiebungen $t_{Fx}$ in bezug auf $U_1$ von t vorgenommen. Durch derartige Verschiebungen ergeben sich phasenrichtige Strom-Spannungsvektoren auf der Sekundärseite der Wandlermeßeinrichtung.

**BEZUGSZEICHEN**

4    Ausgang
5    Ausgang

6    Eingang
7    Eingang
8    Anpassungsverstärker
10   Sample-Hold-Einheiten
11   Multiplexer
12   Ausgang zu einem A/D-Wandler
13   A/D-Wandler
14   μ-Prozessor

**Patentansprüche**

1.  Elektronische Anordnung zur Erfassung von Meßgrößen wie Wirkleistung, Blindleistung, Wirkfaktor und Blindfaktor, insbesondere nach DIN 40110, in einem Einphasen- oder Mehrphasensystem, bei welchem Spannungs- und Stromwandler sekundärseitig sternförmig zusammengeschaltet sind und digital abtastbar sind,
    **gekennzeichnet durch**
    **folgende Merkmale:**
    a) Die Ausgänge (4, 5) der Spannungs- und Stromwandler ($U_1$, $U_2$, $U_3$; $I_1$, $I_2$, $I_3$) sind mit je einem Anpassungsverstärker (8) verbunden;
    b) eine Mehrzahl von Sample-Hold-Speichereinheiten (10) ist eingangsseitig mit dem Ausgang des zugeordneten Anspassungsverstärkers (8) verbunden;
    c) der Ausgang einer jeden Sample-Hold-Speichereinheit (10) ist mit den Eingängen eines Multiplexers (11) verbunden, wobei eine analoge Zwischenspeicherung der Momentanwerte aller Eingangsgrößen für die Dauer der nachfolgenden seriellen Analog/Digital-Wandlung in einem mit dem Multiplexer ausgangsseitig verbundenen Analog/Digital-Konverter vorgesehen ist und wobei die Spannungs- und Stromvektoren der Wandler ($U_1$, $U_2$, $U_3$; $I_1$, $I_2$, $I_3$) auf der Sekundärseite mit einem Phasenfehler abgebildet sind;
    d) mit dem Multiplexer (11) und/oder den Sample-Hold-Speichereinheiten (10) und/oder dem Analog/Digital-Konverter (13) ist ein Mikroprozessor (14) verbunden, mit dem die jeweiligen Abtastzeitpunkte t1, t2 ... tn der Sample-Hold-Einheiten (10) um einen Fehlbetrag $t_{Fx}$ verschiebbar sind und wobei solche Momentanwerte der Eingangsgrößen verknüpfbar sind, die mit einer synchronen Abtastung zeitlich korrelieren.

2.  Elektronische Anordnung nach Anspruch 1,
    **gekennzeichnet durch**
    eine Einrichtung zur Erfassung der Zeitdauer der Grundschwingungsperiode einer Meßgröße und zur Vornahme einer frequenzunabhängigen Durchführung der Phasenkorrektur mittels einer Korrektur des Fehlbetrages $t_{Fx}$.

3.  Verfahren zur Erfassung von Meßgrößen wie Wirkleistung, Blindleistung, Wirkfaktor und Blindfaktor, insbesondere nach DIN 40110 in einem Einphasen- oder Mehrphasensystem, bei welchem Spannungs- und Stromwandler (Meßwandler) sekundärseitig sternförmig zusammengeschaltet und digital abtastbar sind,
    **gekennzeichnet durch**
    **folgende Verfahrensschritte:**
    a) Beschaltung der Meßwandler mit definierten, bekannten Meßgrößen bestehend aus Spannung und Strom;
    b) Ermittlung der relativen Phasenfehler der Meßwandler untereinander und insbesondere im Bezug auf die Phase eines Meßwandlers, wobei der Phasenfehler mittels eines Mikroprozessors aus den digitalen Abtastwerten errechnet wird;
    c) Berechnung der Meßzeitpunktverschiebung für jeden Meßwandler aus dem jeweiligen Phasenfehler;
    d) Festlegung aller Meßzeitpunkte bzw. aller Abtastzeitpunkte für die bestehende Wandleranordnung, um einen phasenrichtigen Meßzyklus zu erreichen.

4.  Verfahren nach Anspruch 3,
    **dadurch gekennzeichnet,**
    daß die Meßzeitpunktverschiebung für jeden Wandler abgespeichert wird, um sie bei einer sich zyklisch

EP 0 591 942 A1

wiederholenden Meßwertabtastung ohne Phasenfehler verwenden zu können.

5. Verfahren nach Anspruch 4,
   **gekennzeichnet durch**

Heranziehung der abgespeicherten Meßzeitpunktverschiebung auch für andere Eingangsbedingungen wie veränderte Netzfrequenz und Leerlaufstrom $I_0$ der Meßwandler, (wobei $I_0$ = Magnetisierungsstrom $I_\mu$ + Eisenveruluststrom $I_{Fe}$).

5

I1    I2    I3    U1    U2    U3    N

Verstärker

| V 8 6 | V 8 6 | V 8 6 | V 5 7 | V 5 7 | V 5 7 |

Sample/
Hold

| S/H | S/H | S/H | S/H | S/H | S/H |

10

| 11  Multiplexer |   | μP 14 |

12

| 13  A/D |

**FIG.1**

**FIG.2**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| Y<br>A | EP-A-0 377 282 (GENERAL ELECTRIC CO.)<br>* Spalte 2, Zeile 17 - Zeile 35;<br>Abbildungen 1,3,4 *<br>--- | 1<br>3 | G01R21/00<br>G01R21/133<br>G01R11/20 |
| Y<br>A | DE-A-36 11 680 (BROWN, BOVERI & CIE)<br>* Spalte 4, Zeile 8 - Spalte 5, Zeile 22;<br>Abbildung 1 *<br>--- | 1<br>3 | |
| A | EP-A-0 466 453 (POLYMETERS RESPONSE INT.)<br>* Zusammenfassung; Abbildungen 1,3,5 *<br>----- | 1,3 | |

**RECHERCHIERTE SACHGEBIETE (Int.Cl.5)**

G01R

Der vorliegende Recherchenbericht wurde für alle Patentansprüche erstellt

| Recherchenort | Abschlußdatum der Recherche | Prüfer |
|---|---|---|
| DEN HAAG | 19. Januar 1994 | Iwansson, K |